# EUROPEAN PATENT SPECIFICATION

(11) **EP 3 572 561 B1**
(45) Date of publication and mention of the grant of the patent: **28.06.2023**
(21) Application number: 18744070.6
(22) Date of filing: 24.01.2018
(51) Int. Cl.: C30B 29/16, C30B 13/00, H01L 31/032, C30B 13/34, C30B 33/02

(54) **GALLIUM OXIDE-DOPED CRYSTALLINE MATERIAL, PREPARATION METHOD AND APPLICATION THEREOF**
GALLIUMOXID-DOTIERTES KRISTALLINES MATERIAL, HERSTELLUNGSVERFAHREN UND ANWENDUNG DAVON
MATÉRIAU CRISTALLIN DOPÉ À L'OXYDE DE GALLIUM, SON PROCÉDÉ DE PRÉPARATION ET APPLICATION

(30) Priority: 25.01.2017 CN 201710061035; 03.03.2017 CN 201710124917
(43) Date of publication of application: 27.11.2019
(73) Proprietor: Hangzhou Fujia Gallium Technology Co. Ltd., Fuyang District Hangzhou Zhejiang 311400 (CN); Shanghai Institute of Optics and Fine Mechanics Chinese Academy of Sciences, Shanghai 201800 (CN)
(72) Inventor: XIA, Changtai, Shanghai 201800 (CN); SAI, Qinglin, Shanghai 201800 (CN); ZHOU, Wei, Shanghai 201800 (CN); QI, Hongji, Shanghai 201800 (CN)
(74) Representative: Stiel, Jürgen
(86) International application number: PCT/CN2018/074058
(87) International publication number: WO 2018/137673

(56) References cited:
- EP-A1- 2 765 610
- WO-A1-2016/152335
- CN-A- 1 469 842
- CN-A- 102 431 977
- CN-A- 103 878 010
- JP-A- 2004 262 684
- ZHOU WEI ET AL: "Controlling n-type conductivity of[beta]-Ga2O3by Nb doping", APPLIED PHYSICS LETTERS, A I P PUBLISHING LLC, US, vol. 111, no. 24, 15 December 2017 (2017-12-15), XP012224597, ISSN: 0003-6951, DOI: 10.1063/1.4994263 [retrieved on 2017-12-15]

## Description

### TECHNICAL FIELD

The present invention relates to crystalline material of β-Ga₂O₃ doped with group VB elements and preparation method and application thereof.

### BACKGROUND ART

β-Ga₂O₃ is a direct wide bandgap semiconductor material with a bandgap of approximately 4.8-4.9 eV. The material has many advantages including wide bandgap, fast drift velocity of saturated electrons, high thermal conductivity, high breakdown voltage, and stable chemical properties, and the region from the deep ultraviolet (DUV) to the infrared (IR) is transparent. Compared with traditional transparent conductive materials, the material based on β-Ga₂O₃ may be used to prepare a new generation of semiconductor optoelectronic devices with shorter wavelength.

Pure β-Ga₂O₃ crystals exhibit semi-insulating or weakly n-type conductive. Currently, known major method to improve the n-type conductivity of the β-Ga₂O₃ crystals is to carry out tetravalent ion (group IV elements) doping, from the fourth main group and the fourth subgroup, which mainly includes doping with ions of Si, Hf, Ge, Sn, Zr, Ti, etc. Taking Si as an example, the main mechanism of improving carrier concentration is as follows:

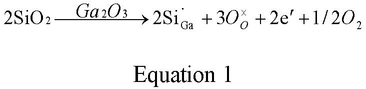

The equation shows that the theoretical ultimate ability of free electron supply by Group IV Element doping is about 1:1. With the increase in doping concentration, the difficulty of crystalline crystallization increases, and the improvement of conductivity is limited.

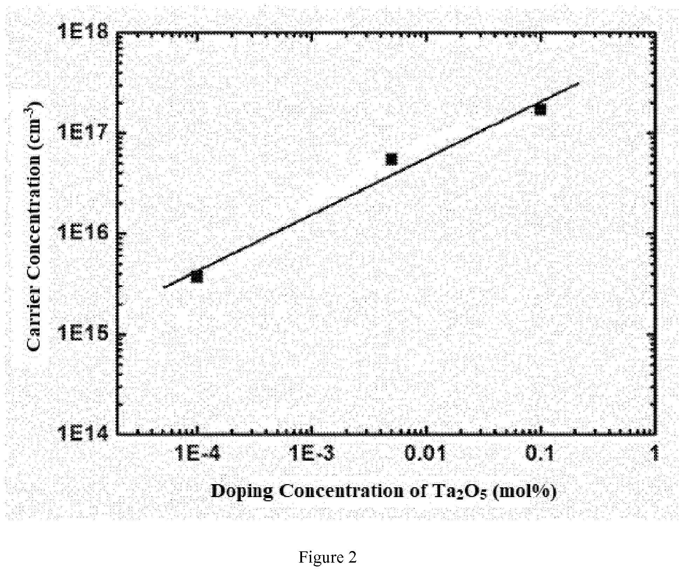

Among Group IV elements, Si and Sn are the two commonly used for doping. The use of Si for doping with single crystals β-Ga₂O₃ is disclosed in U.S. Patent Document US20070166967A1 and Japanese Patent Document JP2015083536A. Although the above two documents report resistivity in the 2.0×10⁻³ to 8.0×10²Ω·cm range of Si doped single crystals β-Ga₂O₃, the lowest resistance rate of 2.0×10⁻³ Ω·cm is only theoretical. Since the radius of Si⁴⁺ and Ga³⁺ is very different, with the increase of Si doping concentration, a second phase will precipitate out, leading to the decrease of crystalline quality. For example, the highest Si doping concentration obtained in US20070166967A1 and JP2015083536A were only about 0.2 mol% in the doped single β-Ga₂O₃ crystal, referring to Applied Physics Letters, 2008, 92, 202120, and the resistivity of the doped crystal is approximately 2.0×10⁻² Ω·cm (specifically referring to figure 2 of the description).

Sn doped single crystals β-Ga₂O₃ have been reported in the journal (Thin Solid Films, 2008, 516 (17), 5763-5767). However, due to the high volatility of tin oxides, the Sn content in the obtained crystals is only in ppm level even though 2-10 mol% Sn is added to the raw material. It not only brings great difficulty to control its content and uniformity, but also causes equipment pollution by the volatilization of tin oxide.

Document EP2765610 A1 discloses a high-quality Ga₂O₃ semiconductor element including an n-type β-Ga₂O₃ substrate; a β-Ga₂O₃ single crystal film which is formed on the n-type β-Ga₂O₃ substrate; source electrodes which are formed on the β-Ga₂O₃ single crystal film; a drain electrode, which is formed on the n-type β-Ga₂O₃ substrate surface on the reverse side of the β-Ga₂O₃ single crystal film; n-type contact regions, which are formed in the β-Ga₂O₃ single crystal film, and have the source electrodes connected thereto, respectively; and a gate electrode, which is formed on the β-Ga₂O₃ single crystal film with the gate insulating film therebetween.

Document WO2016/152335 A1 discloses a crystal laminate structure including a β-Ga₂O₃ based substrate; a β-Ga₂O₃ based single crystal film formed by epitaxial crystal growth on a primary face of the β-Ga₂O₃ based substrate and including Cl and a dopant doped in parallel with the crystal growth at a concentration of 1×10¹³ to 5.0×10²⁰ atoms/cm³.

Therefore, how to prepare doped β-Ga₂O₃ with high conductivity in a simple way has become an important research topic in this field.

### DISCLOSURE OF THE INVENTION

The problem to be solved by the present invention is overcoming the limitation on the degree of improvement in the conductivity of the Group IV elements doped crystalline β-Ga₂O₃, difficulty in crystallization and harsh process conditions in preparing Group IV element doped crystalline β-Ga₂O₃, with high conductivity. The present invention provides a class of Group VB element doped β-Ga₂O₃ crystalline material, preparation method and application thereof. The crystalline material doped with Group VB elements of the present invention exhibits n-type conductive characteristics, and β-Ga₂O₃ crystalline materials with high conductivity may be prepared by conventional process.

Generally, doping ions with higher valence state than Ga³⁺ in crystalline β-Ga₂O₃ can improve the conductivity to some extent. However, it is generally believed that if the doping ion valence state is too high, the charge is difficult to balance, and it is easy to produce more doping defects. Defects can trap electrons, significantly reduce the number of carriers that can move freely, fail to effectively achieve the purpose of improving the conductivity by doping high valence ions, and seriously affect the application performance of materials. Therefore, currently technologies usually use Group IV elements with one higher valence than Ga³⁺ to dope β-Ga₂O₃ crystals, and Group VB elements have not been reported to dope crystals.

However, through scientific design and experimental verification, the inventor of the present invention has found that certain amount of pentavalent Group VB (M=Nb, Ta, V, etc.) metal ion doped crystalline β-Ga₂O₃ provides more free electrons than that of the commonly tetravalent ions doping, thus improving the carrier concentration and thereby facilitating the improvement of the conductivity. Moreover, the conductivity of the β-Ga₂O₃ crystalline material is regulated by the content control of doped element M. The main defect reaction mechanism is as follows:

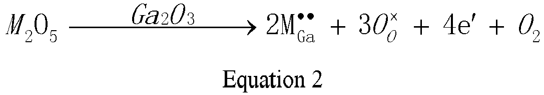

As seen from the above equation, the theoretical ultimate ability of free electron supply by doping elements of Group VB can be 1:2, and the improvement in conductivity is significantly greater than that of Group IV elements. Therefore, crystals is obtained at high doping concentration by using conventional process.

Further, the inventor of the present invention has found that after annealing the crystalline β-Ga₂O₃ doped with Group VB elements, the oxygen vacancy in the crystal is removed, and the control range of carrier concentration is increased, providing a basis for expanding its application range.

The present invention solves the above technical problems through the following technical solutions.

The present invention provides a doped gallium oxide crystalline material, wherein the doped gallium oxide crystalline material is a Group VB element M-doped β-Ga₂O₃ crystalline material, the doped Group VB element M is vanadium (V), niobium (Nb), tantalum (Ta), or a combination thereof, and the doped gallium oxide crystalline material is adjusted by controlling a doping concentration of the Group VB element M and annealing the doped gallium oxide crystalline material at annealing temperature from 1000 °C to 1200°C for 3-10 hours to have at least one of a resistivity in a range of 2.0x10⁻⁴ to 1×10⁴ Ω·cm and a carrier concentration in the range of 5×10¹² to 7×10²⁰/cm³, wherein a molecular formula of the doped gallium oxide crystalline material is Ga₂₍₁₋ₓ₎M₂ₓO₃, and x is defined as 0.000000001≤x≤0.01.

The present invention further provides a method for preparing an M-doped β-Ga₂O₃ crystalline material. The method includes mixing M₂O₅ and Ga₂O₃, both the M₂O₅ and Ga₂O₃ having a purity of above 4N, in a molar ratio of (0.000000000001-0.01): (0.9999999-0.99) to grow crystals, obtaining an M-doped gallium oxide crystalline material; and annealing the M-doped β-Ga₂O₃ crystalline material at annealing temperature from 1000 °C to 1200°C for 3-10 hours after crystal growth, wherein the M is a Group VB element, wherein the Group VB element is vanadium (V), niobium (Nb), tantalum (Ta), or a combination thereof.

The invention is set out in the appended set of claims.

The present invention provides a Group VB element-doped β-Ga₂O₃ crystalline material, doped elements M=Nb, Ta, V, etc. The doped crystal belongs to monoclinic crystalline system and the space group is C2/m. The doped β- Ga₂O₃ crystalline material described has a resistivity in 2.0×10⁻⁴ to 1 ×10⁴ Ω·cm range and/or a carrier concentration ranging from 5×10¹² to 7×10²⁰/cm³.

In the present invention, the term crystalline material refers to a solid material whose internal structure presents a long range order, including solid crystal and liquid crystal where solid state material is the main component, etc. Among the crystal materials, crystalline material is categorized according to the macroscopic aggregate state and particle diameter of the crystalline particles during the crystallization process to, including, single crystal, thin film, polycrystalline (powder crystal), eutectic, microcrystalline, and nano crystalline, etc. In the present invention, there is no special limitation on the macroscopic existing form of the crystalline material, it can be such as powder, particle, film, etc.

In the present invention, x is defined as 0.000001≤x≤0.01.

In the present invention, the M doped β-Ga₂O₃ crystalline material is preferably M doped β-Ga₂O₃ crystal, and more preferably, M doped β-Ga₂O₃ single crystal.

In the present invention, the resistivity range of M doped β-Ga₂O₃ crystalline material is preferably from 2.0×10⁻³ to 3.6×10² Ω·cm. If M is Ta, the preferred range is from 4×10⁻³ to 7.9 Ω·cm. If M is Nb, the preferred range is from 5.5×10⁻³ to 36 Ω·cm. If M is V, the preferred range is from 3×10⁻² to 50 Ω·cm.

In the present invention, the preferred carrier concentration range of M doped β-Ga₂O₃ crystalline material is from 3.7×10¹⁵ to 6.3×10¹⁹/cm³. If M is Ta, the preferred range is from 3.7×10¹⁵ to 3.0×10¹⁹/cm³. If M is Nb, the preferred range is from 9.55×10¹⁶ to 1.8×10¹⁹/cm³. If M is V, the preferred range is from 5×10¹⁵ to 3.69×10¹⁸/cm³.

Doping scheme provided by the present invention is obtained by the conventional crystal growth method. According to the conventional method in the field, M₂O₅ and Ga₂O₃ with purity above 4N are mixed according to a molar ratio of (0.000000001-0.01) : (0.9999999-0.99) for crystal growth.

In the present invention, the term purity refers to the mass fraction of M₂O₅ or Ga₂O₃ in the sample. Purity 4N means that the mass fraction of M₂O₅ or Ga₂O₃ is 99.99%. When the raw material purity of M₂O₅ or Ga₂O₃ is lower than the required purity, the conductivity of the final crystalline material is affected due to excessive impurities.

In the present invention, the purity of M₂O₅ and Ga₂O₃ is better than 5N, that is, the mass content of M₂O₅ or Ga₂O₃ in the sample is 99.999%. When the M doped β-Ga₂O₃ crystalline material is M doped β-Ga₂O₃ single crystal, the purity of Ga₂O₃ used in the preparation process is better than 6N, that is, the mass content of Ga₂O₃ in the sample is 99.9999%.

In the present invention, the M doped β-Ga₂O₃ crystalline material is annealed to remove defects such as oxygen vacancy in the crystal and increase the control range of the carrier concentration. Conventional annealing temperature and time are used at 1000°C to 1200°C and annealing time of 3-10 hrs.

In the present invention, M doped β-Ga₂O₃ crystalline material can contain impurity elements that are unavoidable during the refining process of the raw materials and impurity elements that are inevitably mixed in during the process. Compared with all compositions, the above impurity element content is preferably below 10ppm.

In the present invention, the crystal growth method and condition used for preparing doped β-Ga₂O₃ crystalline materials are not specifically limited, which may be conventional crystal growth method and condition in the field. When the doped β-Ga₂O₃ crystalline material is a single crystal, the melt method commonly used in the field is used to grow the single crystal. Generally, the melt growth method is to introduce the seed crystal into the melt and control the nucleation of the single crystal, and then carry out the phase transition at the phase interface between the seed crystal and the melt to promote the continuous growth of the crystal, including the Czochralski, edge-defined film fed growth, Bridgman-Stockbarger methods, the optical floating zone method, the flame melting method and so on. The optical floating zone method and edge-defined film fed growth method are both simple and efficient methods. The examples of the present invention adopt the optical floating region method.

Among them, the steps of preparing the M-doped β-Ga₂O₃ single crystal by the optical floating zone method generally include mixing, rod making, sintering, and crystal growth.

In the process, the mixing is carried out by a mixing method conventionally used in the art, such as wet mixing. The kind and amount of the solvent to be used in the wet mixing are not particularly limited as long as the M₂O₅ and Ga₂O₃ are uniformly mixed and the solvent is easily removed later, and a volatile solvent such as ethanol is generally used. After dispersing and mixing M₂O₅ and Ga₂O₃ in a volatile solvent, the solvent is completely volatilized by baking. In order to make the mixing of M₂O₅ and Ga₂O₃ more uniform, the wet mixing is also be carried out by a wet ball milling process, which is conventional in the art, for example 12-24 hrs.

In the process, the rod pressuring can be operated in a manner conventional in the art, and the rod pressuring is generally performed using an isotactic press. Those skilled in the art know that the mixture of M₂O₅ and Ga₂O₃ is powdery and can be easily pressed, and can make the pressing uniform. Therefore, if the mixture has agglomeration before pressing, it can be ground into a powder by grinding, such as by ball milling.

In an embodiment of the present invention, M₂O₅ having a purity above 4N and Ga₂O₃ having a purity of 6N are mixed at a molar ratio of (0.000001-0.01): (0.999999-0.99), and wet ball milling is conducted by adding an appropriate amount of absolute ethanol; ball milling time is 12-24hrs, so that M₂O₅ and Ga₂O₃ are thoroughly mixed. Then, the mixture obtained is baked at 80-100°C for 3-6 hrs to completely evaporate the ethanol, and then the dried mixture is ball-milled into powdery form for use in rod making by pressurizing.

In the process, the sintering can be carried out according to the conventional sintering temperature and time in the art to remove moisture in the M₂O₅ and Ga₂O₃ mixture, and to solid phase reaction of M₂O₅ and Ga₂O₃ to form a polycrystalline material. The sintering temperature is preferably from 1400 to 1600°C, and the sintering time is preferably from 10 to 20 hours. The sintering is generally carried out in a muffle furnace.

In the process, the crystal growth atmosphere is preferably a vacuum, an inert atmosphere, or an oxidizing atmosphere to ensure the valence state of the Group VB metal M ions. The inert atmosphere may be an inert atmosphere conventional in the art, such as a nitrogen atmosphere or an argon atmosphere; the oxidizing atmosphere may be an oxidizing atmosphere conventional in the art, such as an oxygen atmosphere or an air atmosphere.

Among them, the preparation of the Group VB metal M-doped β-Ga₂O₃ single crystal is usually carried out by a melt method. Generally, the β-Ga₂O₃ crystal is used as a seed crystal, and the melt is formed by melting the sintered M₂O₅ and Ga₂O₃ polycrystalline materials, and the melt is gradually cooled and crystallized along the seed crystal to form a single crystal. Specific methods include a floating zone method, edge-defined film fed growth, a temperature gradient method, a Czochralski method, a Bridgman-Stockbarger Method, and the like.

In one embodiment of the present invention, the growing Group VB metal M-doped β- Ga₂O₃ single crystal is carried out by a floating zone method, and the following steps are performed. The sintered M₂O₅ and Ga₂O₃ polycrystalline rods are loaded into the floating zone furnace as the loading rod, and the Ga₂O₃crystal in the <010> direction is used as the seed crystal. Firstly, increase the temperature to melt the seed crystal, then contacts the loading rod, adjusts the rotation speed and rotation direction of the rod and the seed crystal, seeding, starts crystal growth. The growth rate of the crystal is 4.5-6 mm/hr, the rotation speed is 8-12 rpm, and the growth atmosphere is an air atmosphere. After the crystal growth is completed, the crystal is pulled from the melting zone, slowly lowered to room temperature, and the crystal is taken out.

The present invention also provides a Group VB metal M-doped β-Ga₂O₃ crystalline material obtained by the above preparation method.

The present invention also provides the use of the M-doped β-Ga₂O₃ crystalline material on power electronic devices, optoelectronic devices, photo catalysts, or conductive substrates.

In the present invention, the optoelectronic device comprises a transparent electrode, a solar panel, a light emitting device, a photodetector, a sensor, etc. The conductive substrate includes a substrate material for GaN-based and/or AlN-based material, a substrate material for β- Ga₂O₃ itself, and the like.

Based on the common knowledge in the art, the above various preferred conditions can be arbitrarily combined to obtain preferred embodiments of the present invention.

The reagents and starting materials used in the present invention are commercially available.

The positive progress and effects achieved by the present invention are:
(1) In the present invention, the ultimate ability of free electrons supply by doping crystalline β- Ga₂O₃ with pentavalent Group VB metal ion is 1:2, which is significantly higher than the ability of the +4 valence ion doping to provide free electrons (1:1). Therefore, more free electrons are provided at the same doping concentration, which is more favorable for increasing the carrier concentration and improving the conductivity.
(2) The present invention adopts pentavalent Group VB metal ion doped crystalline β-Ga₂O₃, and the conductivity of the β-Ga₂O₃ crystalline material is controlled by controlling the content of the doping element M. The resistivity of Ta-doped β-Ga₂O₃ crystalline material is controlled within a range of 2.0×10⁻⁴ to 1 ×10⁴ Ω·cm and the carrier concentration is controlled within a range of 5×10¹² to 7×10²⁰ /cm³; the resistivity of Nb-doped β-Ga₂O₃ crystalline material is controlled within a range of 2.5×10⁻⁴ to 1×10⁴ Ω·cm, and the carrier concentration is controlled within a range of 5×10¹² to 5.6×10²⁰/cm³; the resistivity of V-doped β-Ga₂O₃ crystalline material is controlled within a range of 2.0×10⁻⁴ to 1×10⁴ Ω·cm, and the carrier concentration is controlled within a range of 5×10¹² to 7×10²⁰/cm³.
(3) The Group VB metal-doped β-Ga₂O₃ crystalline material of the present invention is prepared by a conventional method in the art without expensive raw materials and demanding processes.
(4) After annealing the Group VB metal doped crystalline β-Ga₂O₃, the oxygen vacancies in the crystal lattice are removed, and the control range of the carrier concentration increases, thereby providing a basis for its application.

### DRAWINGS

Figure 1 is a graph showing the relationship between the doping concentration of Ta₂O₅ and the carrier concentration and resistivity of the Ta-doped β-Ga₂O₃ as-grown crystal of Example 1-4 in the present invention.
Figure 2 is a graph showing the relationship between the doping concentration of Ta₂O₅ after annealing and the carrier concentration of the Ta-doped β-Ga₂O₃ crystal after annealing of Example 1-3 in the present invention.
Figure 3 is a graph showing the relationship between the doping concentration of Nb₂O₅ and the carrier concentration and resistivity of the Nb-doped β-Ga₂O₃ as-grown crystal of Example 5-9 in the present invention.

### DETAILED DESCRIPTION OF THE INVENTION

The present invention is further illustrated in the following examples, without thereby limiting the present invention to the scope of the examples. The experimental methods in the following examples which do not specify the specific conditions are selected according to conventional methods and conditions, or according to the product specifications.

In the following examples, the starting materials and reagents used are commercially available.

### Example 1

A Ta-doped β-Ga₂O₃ single crystal with a molecular formula of Ga2₍₁₋ₓ₎Ta₂ₓO₃ (x=0.000001), which belongs to the monoclinic system and has a space group of C2/m, is prepared by the method and specific steps as follows:
(1) Ingredients: Ga₂O₃ with a purity above 6N and Ta₂O₅ with a purity above 4N are weighed according to a molar ratio of 0.999999:0.000001;
(2) Mixing: put the weighed raw materials into a clean PTFE ball mill jar, put into a highpurity corundum ball, pour the appropriate amount of absolute ethanol, seal, put into a ball mill, and mix for 12 hrs;
(3) Drying: the ball grinding tank is placed in an oven, baked at 80°C for 6 hrs, the ethanol is completely volatilized, and then placed in a ball mill for 10 minutes to grind the dried bulk material into powder form;
(4) Rod making: the dried mixed powder is placed in an organic mold and pressed into a material rod by using an isotactic press;
(5) Sintering: the pressed rod is placed in a muffle furnace and sintered at 1500°C for 10 hrs, the moisture in the raw material is removed, and the Ta₂O₅ and the Ga₂O₃ raw material are subjected to solid phase reaction to form a polycrystalline material;
(6) Crystal growth: the sintered polycrystalline rod is placed in a floating zone furnace as an loading rod, and the Ga₂O₃ crystal in the <010> direction is placed below as a seed crystal. First, temperature is increased to melt the seed crystal, and then the seed crystal is contacted with the loading rod to reach stabilization and initiate crystal growth. The crystal growth rate is 5 mm/hr, the rotation speed is 10rpm, and the growth atmosphere is air atmosphere. After the crystal growth is completed, stop the dropping of the loading rod, and cause the gradual separation of the melting zone by naturally lowering down the crystal. After about 1 hour, the temperature slowly drops to room temperature, and the crystal is taken out. The as-grown crystal is intact with even color and no cracking;
(7) Annealing: The resulting as-grown crystals are annealed at 1000°C for 3 hrs.

### Example 2

A Ta-doped β-Ga₂O₃ single crystal with a molecular formula of Ga₂₍₁₋ₓ₎Ta₂ₓO₃ (x=0.00005), which belongs to the monoclinic system and has a space group of C2/m, is prepared by the same steps and conditions as in Example 1, except that the doping concentration of Ta₂O₅ in step (1) is different, and the molar ratio of Ga₂O₃ to Ta₂O₅ is 0.99995:0.00005.

### Example 3 (not in accordance with the present invention)

A Ta-doped β- Ga₂O₃ single crystal with a molecular formula of Ga₂₍₁₋ₓ₎Ta₂ₓO3 (x=0.001), which belongs to the monoclinic system and has a space group of C2/m, is prepared by the same steps and conditions as in Example 1, except that the doping concentration of Ta₂O₅ in step (1) is different, and the molar ratio of Ga₂O₃ to Ta₂O₅ is 0.999:0.001. Additionally, no annealing operation is performed.

### Example 4 (not in accordance with the present invention)

A Ta-doped β- Ga₂O₃ single crystal with a molecular formula of Ga₂₍₁₋ₓ₎Ta₂ₓO₃(x=0.01), which belongs to the monoclinic system and has a space group of C2/m, is prepared by the same steps and conditions as in Example 1, except that the doping concentration of Ta₂O₅ in step (1) is different, and the molar ratio of Ga₂O₃ to Ta₂O₅ is 0.99:0.01. No annealing operation is performed.

### Example 5

A Nb-doped β-Ga₂O₃ single crystal with a molecular formula of Ga₂₍₁₋ₓ₎Nb₂ₓO₃ (x=0.000001), which belongs to the monoclinic system and has a space group of C2/m, is prepared by the same steps and conditions as in Example 1, except that the dopant (Nb₂O₅) and doping concentration of Nb₂O₅ in step (1) are different. The preparation steps and conditions are the same as those in example 1.

### Example 6

A Nb-doped β-Ga₂O₃ single crystal with a molecular formula of Ga₂₍₁₋ₓ₎Nb₂ₓO₃ (x=0.00001), which belongs to the monoclinic system and has a space group of C2/m, is prepared by the same steps and conditions as in Example 1, except that the dopant (Nb₂O₅) and doping concentration of Nb₂O₅ in step (1) are different. The preparation steps and conditions are the same as those in example 1.

### Example 7 (not in accordance with the present invention)

A Nb-doped β-Ga₂O₃ single crystal with a molecular formula of Ga₂₍₁₋ₓ₎Nb₂ₓO₃ (x=0.0001), which belongs to the monoclinic system and has a space group of C2/m, is prepared by the same steps and conditions as in Example 1, except that the dopant (Nb₂O₅) and doping concentration of Nb₂O₅ in step (1) are different. The preparation steps and conditions are the same as those in example 1. No annealing operation is performed.

### Example 8 (not in accordance with the present invention)

A Nb-doped β-Ga₂O₃ single crystal with a molecular formula of Ga₂₍₁₋ₓ₎Nb₂ₓO₃ (x=0.002), which belongs to the monoclinic system and has a space group of C2/m, is prepared by the same steps and conditions as in Example 1, except that the dopant (Nb₂O₅) and doping concentration of Nb₂O₅ in step (1) are different. The preparation steps and conditions are the same as those in example 1. No annealing operation is performed.

### Example 9 (not in accordance with the present invention)

A Nb-doped β-Ga₂O₃ single crystal with a molecular formula of Ga₂₍₁₋ₓ₎Nb₂ₓO₃ (x=0.008), which belongs to the monoclinic system and has a space group of C2/m, is prepared by the same steps and conditions as in Example 1, except that the dopant (Nb₂O₅) and doping concentration of Nb₂O₅ in step (1) are different. The preparation steps and conditions are the same as those in example 1. No annealing operation is performed.

### Example 10 (not in accordance with the present invention)

A V-doped β-Ga₂O₃ single crystal with a molecular formula of Ga₂₍₁₋ₓ₎V₂ₓO₃ (x=0.01), which belongs to the monoclinic system and has a space group of C2/m, is prepared by the same steps and conditions as in Example 1, except that the dopant (V₂O₅) and doping concentration of V₂O₅ in step (1) are different. The preparation steps and conditions are the same as those in example 1. No annealing operation is performed.

### Example 11 (not in accordance with the present invention)

A V-doped β-Ga₂O₃ single crystal with a molecular formula of Ga₂₍₁₋ₓ₎V₂ₓO₃ (x=0.00001), which belongs to the monoclinic system and has a space group of C2/m, is prepared by the same steps and conditions as in Example 1, except that the dopant (V₂O₅) and doping concentration of V₂O₅ in step (1) are different. The preparation steps and conditions are the same as those in example 1. No annealing operation is performed.

### Comparative Example

A pure β-Ga₂O₃ single crystal without Ta₂O₅ doping is prepared by the same steps and conditions as in Example 1.

The M-doped maple- Ga₂O₃ single crystals obtained in Examples 1-12 and the pure Ga₂O₃ single crystal in the comparative example (including the as-grown crystal and the annealed crystal) are cut into samples with the size of 5 mm×5 mm×0.3 mm. Four Indium electrodes are fabricated on four corners of each of the samples and Hall measurements are taken. The measurement results show that all doped crystal samples of Examples 1-12 show n-type conductivity, and detail results of carrier concentration and resistivity of samples in Examples 1-4, 7-12 and Contrastive Example are as shown in Table 1.

**Table 1. Carrier concentration and resistivity of different examples in Examples 1-13 and Comparative Example**

| Samples | Dopants | carrier concentration (/cm³) | | Resistivity (Ω·cm) | |
|---|---|---|---|---|---|
| | | as-grown | after annealing | as-grown | after annealing |
| Example 1 | Ta=0.000001 | 7.12×10¹⁷ | 3.7×10¹⁵ | 0.13 | 7.9 |
| Example2 | Ta=0.00005 | 1.44×10¹⁸ | 5.4×10¹⁶ | 0.04 | 0.86 |
| Examples | Ta=0.001 | 6.3×10¹⁸ | 1.7×10¹⁷ | 0.02 | - |
| Example4 | Ta=0.01 | 3.0×10¹⁹ | - | 0.004 | - |
| Example5 | Nb=0.000001 | 2.014×10¹⁸ | 9.554×10¹⁶ | 0.07746 | 36.63 |
| Example6 | Nb=0.00001 | 7.484×10¹⁸ | 2.613×10¹⁷ | 0.01584 | 2.065 |
| Example7 | Nb=0.0001 | 1.596×10¹⁸ | - | 0.09291 | - |
| Examples | Nb=0.002 | 8.818×10¹⁸ | - | 0.009181 | - |
| Example9 | Nb=0.008 | 1.812×10¹⁹ | - | 0.005523 | - |
| Example 10 | V=0.01 | 3.69×10¹⁸ | | 0.03 | |
| Example 11 | V=0.000001 | 2.68×10¹⁷ | - | 0.54 | - |
| Contrastive example | - | 3.96×10¹⁴ | exceeding limit of detection | 67 | exceeding limit of detection |

According to the data from Table 1, the pure as-grown crystal of β-Ga₂O₃ is almost insulated after annealing. Compared with the pure β-Ga₂O₃ as-grown crystal, the carrier concentration and conductivity of β-Ga₂O₃ single crystal doped with Group VB elements increase significantly, and the carrier concentration increase at least 10³ times and the resistivity decrease at least 500 times, indicating that M metal ions have been successfully doped into the lattice of β-Ga₂O₃ and achieve desired control effect.

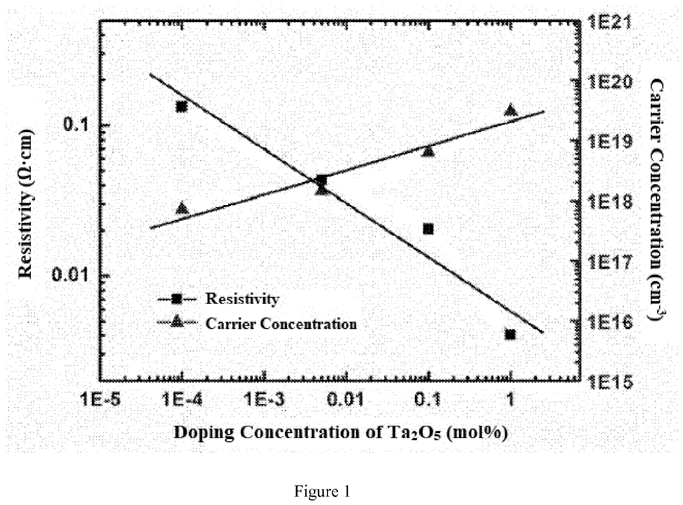

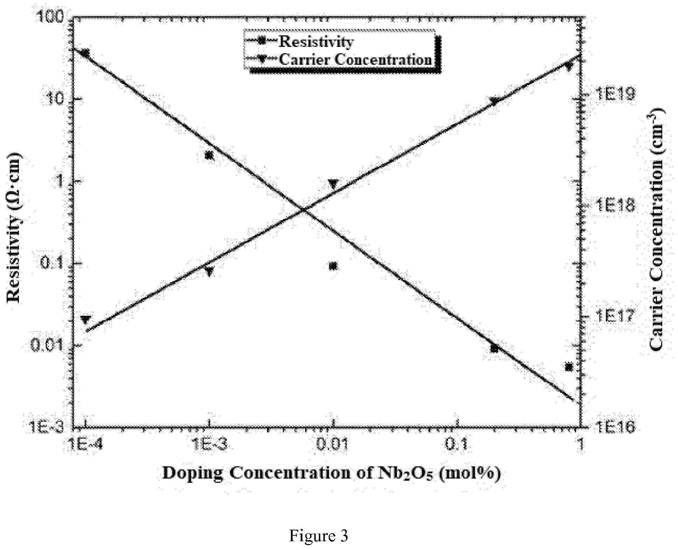

Further, in order to study the relationship between different doping concentrations and carrier concentration or resistivity in the as-grown crystal, the Ta₂O₅ doping concentration-carrier concentration-resistivity curve of samples without annealing in Examples 1-4 are shown in Fig.1. Examples 5-9 correspond to the curve of NbzOs doping concentration-carrier concentration-resistivity, as shown in Figure 3. In addition, in order to study the relationship between the doping concentration of Ta₂O₅ and carrier concentration after annealing, the present invention draws the doping concentration-carrier concentration curve of the samples annealed in Examples 1-3 as shown in Fig. 2.

It can be seen from Figs. 1 and 3 that there is a linear relationship between M₂O₅ doping concentration and carrier concentration, and between M₂O₅ doping concentration and resistivity. Within the doping concentration range of the present invention, the carrier concentration increases linearly and the resistivity decreases linearly with the increase of M₂O₅ doping concentration before annealing. As shown in Figure 2, the carrier concentration decreases after annealing.

It should be noted that the carrier concentration and resistivity of the above Group VB elements doped β- Ga₂O₃ single crystal are obtained by the specific experiments of the present invention. Due to the influence of the purity of raw materials, preparation technology and test conditions, the measured carrier concentration and resistivity of the doped crystal will be different from the theoretical value, or there is a situation that cannot be detected. Therefore, the above examples are merely illustrations. According to the Group VB element doping concentration disclosed by the present invention and the common knowledge in the field, it can be inferred that the carrier concentration of the Group VB element doped β- Ga₂O₃ crystalline material can be controlled in the range of 5×10¹² to 7×10²⁰/cm³, and the resistivity can be controlled in the range of 2.0×10⁻⁴ to 1×10⁴ Ω·cm. Taking Taas an example, the specific calculation process is as follows.

According to the experiment of the present invention, the maximum value of Tadoping concentration in the β- Ga₂O₃ single crystal is 1 at% (i.e. x=0.01).

The volume of 1 mole β-Ga₂O₃ is 184.44/5.94cm³=31cm³;
The number of Ta atoms in 1 mole Ta-doped β- Ga₂O₃ is: 1 ×2×1%×6.023×10²³=1.2×10²²; therefore, the theoretical value of carrier concentration of Ta-doped β-Ga₂O₃ is 2×1.2×10²²/31=7.7×10²⁰/cm³.

The Hall effect instrument with low resistance module is used to test the resistivity below the limit value of 10⁵ Ω·cm. The experiment of the present invention shows that the resistivity of 6N pure β-Ga₂O₃ crystal exceeds the test limit after annealing, indicating that the resistivity of 6N pure β-Ga₂O₃ crystal exceeds 10⁵ Ω·cm. Therefore, the resistivity of 6N pure β-Ga₂O₃ doped with Ta can be controlled to 1×10⁴ Ω·cm, which is 1/1266 of Example 1. The carrier concentration in the example is multiplied by 1/1266, 3×10¹²/cm³ can be obtained, so it is feasible to achieve 5×10¹²/cm³ carrier concentration in Ta-doped β-Ga₂O₃ crystalline material.

The doping concentration of Ta corresponding to the doping concentration is 10⁻⁷ at%.

Therefore, the amount of Ta doping in Ta-doped β-Ga₂O₃ crystalline materials can be controlled in the range of x=0.000000001 to 0.01, the resistivity can be controlled in the range of 2.0×10⁻⁴ to 1×10⁴ Ω·cm, and the carrier concentration can be controlled in the range of 5×10¹² to 7×10²⁰ /cm³.

Other doped elements including Nb and V may be calculated by the same method.

The examples of the present invention are described above. The scope of protection advocated by the present invention shall prevail as described in the claims.

## Claims

1. A doped gallium oxide crystalline material, wherein the doped gallium oxide crystalline material is a Group VB element M-doped β-Ga₂O₃ crystalline material, the doped Group VB element M is vanadium (V), niobium (Nb), tantalum (Ta), or a combination thereof, and the doped gallium oxide crystalline material is adjusted by controlling a doping concentration of the Group VB element M and annealing the doped gallium oxide crystalline material at annealing temperature from 1000 °C to 1200°C for 3-10 hours to have at least one of a resistivity in a range of 2.0×10⁻⁴ to 1×10⁴ Ω·cm and a carrier concentration in the range of 5×10¹² to 7×10²⁰/cm³, wherein a molecular formula of the doped gallium oxide crystalline material is Ga₂₍₁₋ₓ₎M₂ₓO₃., and x is defined as 0.000000001≤x≤0.01.

2. The doped gallium oxide crystalline material of claim 1, wherein the gallium oxide is a monoclinic β-Ga₂O₃ crystal with a space group of C2/m.

3. The doped gallium oxide crystalline material of claim 1, wherein x is defined as 0.0000011≤x≤0.01.

4. The doped gallium oxide crystalline material of claim 1 or 2, wherein the doped gallium oxide crystalline material is Ta-doped β-Ga₂O₃ crystalline material, and the Ta-doped β-Ga₂O₃ crystalline material has at least one of a resistivity in a range of 2.0×10⁻⁴ to 1 ×10⁴ Ω·cm and a carrier concentration in a range of 5×10¹² to 7×10²⁰/cm³.

5. The doped gallium oxide crystalline material of claim 4, wherein the molecular formula of the Ta-doped β-Ga₂O₃ crystalline material is Ga₂₍₁₋ₓ₎Ta₂ₓO₃, 0.000001≤x≤0.01.

6. The doped gallium oxide crystalline material of claim 1 or 2, wherein the doped gallium oxide crystalline material is a Nb-doped β-Ga₂O₃ crystalline material having at least one of a resistivity in a range of 2.5×10⁻⁴ to 1 ×10⁴Ω·cm and a carrier concentration in a range of 5×10¹² to 5.6×10²⁰/cm³.

7. The doped gallium oxide crystalline material of claim 6, wherein the molecular formula of the Nb-doped β-Ga₂O₃ crystalline material is Ga₂₍₁₋ₓ₎Nb₂ₓO₃, 0.000001≤x≤0.008.

8. The doped gallium oxide crystalline material of claim 1 or 2, wherein the doped gallium oxide crystalline material is V-doped β-Ga₂O₃ crystalline material having at least one of a resistivity in a range of 2.0×10⁻⁴ to 1×10⁴ Ω·cm and a carrier concentration in a range of 5×10¹² to 7×10²⁰/cm³.

9. The doped gallium oxide crystalline material of claim 8, wherein the molecular formula of the V-doped β-Ga₂O₃ crystalline material is Ga₂₍₁₋ₓ₎V₂ₓO₃. 0.000001≤x≤0.01.

10. The doped gallium oxide crystalline material of claim 9, wherein the V-doped β-Ga₂O₃ crystalline material is V doped β-Ga₂O₃ crystal;
the V-doped β-Ga₂O₃ crystalline material has at least one of a resistivity in a range of 2.0×10⁻³ to 3.6×10² Ω·cm and carrier concentration in a range of 3.7×10¹⁵ to 6.3×10¹⁹/cm³.

11. The doped gallium oxide crystalline material of claim 10, wherein the V-doped β-Ga₂O₃ crystalline material is V-doped β-Ga₂O₃ single crystal;
the V-doped β-Ga₂O₃ crystalline material has at least one of a resistivity in a range of 3×10⁻² to 50 Ω·cm and a carrier concentration in a range of 5×10¹⁵ to 3.69×10¹⁸/cm³.

12. A method for preparing an M-doped β-Ga₂O₃ crystalline material, comprising:
mixing M₂O₅ and Ga₂O₃, both the M₂O₅ and Ga₂O₃ having a purity of above 4N, in a molar ratio of (0.000000000001-0.01): (0.9999999-0.99) to grow crystals, obtaining an M-doped gallium oxide crystalline material, and
annealing the M-doped β-Ga₂O₃ crystalline material at annealing temperature from 1000 °C to 1200°C for 3-10 hours after crystal growth,
wherein the M is a Group VB element, wherein the Group VB element is vanadium (V), niobium (Nb), tantalum (Ta), or a combination thereof.

13. The method of claim 12, wherein the purity of M₂O₅ and Ga₂O₃ are both higher than 5N;
when the M-doped β-Ga₂O₃ crystalline material is an M-doped β-Ga₂O₃ single crystal, the purity of Ga₂O₃ used in preparing process is higher than 6N; and
the molar ratio of M₂O₅ and Ga₂O₃ is in a range of (0.000001-0.01):(0.999999-0.99).

14. The method of claim 12, wherein when the M-doped β-Ga₂O₃ crystalline material is an M-doped β-Ga₂O₃ single crystal, the single crystal is grown by a melt method chosen from any one of an edge defined film-fed growth (EFG) method, Czochralski method, floating zone method, or Bridgman method.

## Patentansprüche

1. Dotiertes kristallines Galliumoxid-Material, wobei das dotierte kristalline Galliumoxid-Material ein mit einem Gruppe-VB-Element M dotiertes kristallines β-Ga₂O₃-Material ist, wobei das dotierte Gruppe-VB-Element M Vanadium (V), Niob (Nb), Tantal (Ta) oder eine Kombination davon ist und das dotierte kristalline Galliumoxid-Material durch Steuern der Dotierkonzentration des Gruppe-VB-Elements M und Glühen des dotierten kristallinen Galliumoxid-Materials bei einer Glühtemperatur von 1000 °C bis 1200 °C für 3-10 Stunden eingestellt wird, um mindestens einen bzw. eine von einem spezifischen Widerstand in einem Bereich von 2,0 × 10⁻⁴ bis 1 × 10⁴ Ω·cm und einer Trägerkonzentration im Bereich von 5 × 10¹² bis 7 × 10²⁰/cm³ aufzuweisen, wobei eine Summenformel des dotierten kristallinen Galliumoxid-Materials Ga₂₍₁₋ₓ₎M₂ₓO₃ ist und x als 0,000000001 ≤ x ≤ 0,01 definiert ist.

2. Dotiertes kristallines Galliumoxid-Material nach Anspruch 1, wobei das Galliumoxid ein monokliner β-Ga₂O₃-Kristall mit einer Raumgruppe von C2/m ist.

3. Dotiertes kristallines Galliumoxid-Material nach Anspruch 1, wobei x als 0,0000011 ≤ x ≤ 0,01 definiert ist.

4. Dotiertes kristallines Galliumoxid-Material nach Anspruch 1 oder 2, wobei das dotierte kristalline Galliumoxid-Material ein mit Ta dotiertes kristallines β-Ga₂O₃-Material ist und das mit Ta dotierte kristalline β-Ga₂O₃-Material mindestens einen bzw. eine von einem spezifischen Widerstand in einem Bereich von 2,0 × 10⁻⁴ bis 1 × 10⁴ Ω·cm und einer Trägerkonzentration im Bereich von 5 × 10¹² bis 7 × 10²⁰/cm³ aufweist.

5. Dotiertes kristallines Galliumoxid-Material nach Anspruch 4, wobei die Summenformel des mit Ta dotierten kristallinen β-Ga₂O₃-Materials Ga₂₍₁₋ₓ₎Ta₂ₓO₃ ist, wobei 0,000001 ≤ x ≤ 0,01.

6. Dotiertes kristallines Galliumoxid-Material nach Anspruch 1 oder 2, wobei das dotierte kristalline Galliumoxid-Material ein mit Nb dotiertes kristallines β-Ga₂O₃-Material mit mindestens einem bzw. einer von einem spezifischen Widerstand in einem Bereich von 2,5 × 10⁻⁴ bis 1 × 10⁴ Ω·cm und einer Trägerkonzentration im Bereich von 5 × 10¹² bis 5, 6 × 10²⁰/cm³ ist.

7. Dotiertes kristallines Galliumoxid-Material nach Anspruch 6, wobei die Summenformel des mit Nb dotierten kristallinen β-Ga₂O₃-Materials Ga₂₍₁₋ₓ₎Nb₂ₓO₃ ist, wobei 0, 000001 ≤ x ≤ 0,008.

8. Dotiertes kristallines Galliumoxid-Material nach Anspruch 1 oder 2, wobei das dotierte kristalline Galliumoxid-Material ein mit V dotiertes kristallines β-Ga₂O₃-Material mit mindestens einem bzw. einer von einem spezifischen Widerstand in einem Bereich von 2,0 × 10⁻⁴ bis 1 × 10⁴ Ω·cm und einer Trägerkonzentration im Bereich von 5 × 10¹² bis 7 × 10²⁰/cm³ ist.

9. Dotiertes kristallines Galliumoxid-Material nach Anspruch 8, wobei die Summenformel des mit V dotierten kristallinen β-Ga₂O₃-Materials Ga₂₍₁₋ₓ₎V₂ₓO₃ ist, wobei 0, 000001 ≤ x ≤ 0,01.

10. Dotiertes kristallines Galliumoxid-Material nach Anspruch 9, wobei das mit V dotierte kristalline β-Ga₂O₃-Material ein mit V dotierter β-Ga₂O₃-Kristall ist;
das mit V dotierte kristalline β-Ga₂O₃-Material mindestens einen bzw. eine von einem spezifischen Widerstand in einem Bereich von 2,0 × 10⁻³ bis 3,6 × 10² Ω·cm und einer Trägerkonzentration im Bereich von 3,7 × 10¹⁵ bis 6,3 × 10¹⁹/cm³ aufweist.

11. Dotiertes kristallines Galliumoxid-Material nach Anspruch 10, wobei das mit V dotierte kristalline β-Ga₂O₃-Material ein mit V dotierter β-Ga₂O₃-Einkristall ist;
das mit V dotierte kristalline β-Ga₂O₃-Material mindestens einen bzw. eine von einem spezifischen Widerstand in einem Bereich von 3 × 10⁻² bis 50 Ω·cm und einer Trägerkonzentration im Bereich von 5 × 10¹⁵ bis 3,69 × 10¹⁸/cm³ aufweist.

12. Verfahren zur Herstellung eines mit M dotierten kristallinen β-Ga₂O₃-Materials, umfassend:
Mischen von M₂O₅ und Ga₂O₃, wobei sowohl das M₂O₅ als auch Ga₂O₃ eine Reinheit von mehr als 4 N aufweisen, in einem Molverhältnis von (0,000000000001-0,01):(0,9999999-0,99), um Kristalle wachsen zu lassen, wodurch ein mit M dotiertes kristallines Galliumoxid-Material erhalten wird, und
Glühen des mit M dotierten kristallinen bei einer Glühtemperatur von 1000 °C bis 1200 °C für 3-10 Stunden nach dem Kristallwachstum,
wobei das M ein Gruppe-VB-Element ist, wobei das Gruppe-VB-Element Vanadium (V), Niob (Nb), Tantal (Ta) oder eine Kombination davon ist.

13. Verfahren nach Anspruch 12, wobei die Reinheiten von M₂O₅ und Ga₂O₃ beide höher als 5 N sind;
wenn das mit M dotierte kristalline β-Ga₂O₃-Material ein mit M dotierter β-Ga₂O₃-Einkristall ist, die Reinheit von in dem Herstellungsverfahren verwendeten Ga₂O₃ höher als 6 N ist; und
das Molverhältnis von M₂O₅ und Ga₂O₃ in einem Bereich von (0,000001-0,01):(0,999999-0,99) liegt.

14. Verfahren nach Anspruch 12, wobei, wenn das mit M dotierte kristalline β-Ga₂O₃-Material ein mit M dotierter β-Ga₂O₃-Einkristall ist, der Einkristall durch ein Schmelzverfahren wachsen gelassen wird, das aus einem beliebigen von einem kantendefinierten Filmwachstumsverfahren (EFG-Verfahren), Czochralski-Verfahren, Zonenschmelzverfahren oder Bridgman-Verfahren ausgewählt ist.

## Revendications

1. Matériau cristallin en oxyde de gallium dopé, lequel matériau cristallin en oxyde de gallium dopé est un matériau cristallin en **β**-Ga₂O₃ dopé par un élément M du Groupe VB, lequel élément M du Groupe VB est le vanadium (V), le niobium (Nb), le tantale (Ta), ou une de leurs combinaisons, et lequel matériau cristallin en oxyde de gallium dopé est ajusté par contrôle de la composition de dopage de l'élément M du Groupe VB et recuit du matériau cristallin en oxyde de gallium dopé à une température de recuit de 1000°C à 1200°C pendant 3 à 10 heures pour qu'il ait au moins l'une parmi une résistivité située dans la plage allant de 2,0 × 10⁻⁴ à 1 × 10⁴ **Ω**•cm et une concentration de supports située dans la plage allant de 5 × 10¹² à 7 × 10²⁰/cm³, dans lequel la formule moléculaire du matériau cristallin en oxyde de gallium dopé est Ga₂₍₁₋ₓ₎M₂ₓO₃, et x est défini par 0,000000001 ≤ x ≤ 0,01.

2. Matériau cristallin en oxyde de gallium dopé selon la revendication 1, dans lequel l'oxyde de gallium est un cristal de **β**-Ga₂O₃ monolithique avec un groupe spatial de C2/m.

3. Matériau cristallin en oxyde de gallium dopé selon la revendication 1, dans lequel x est défini par 0,0000011 ≤ x ≤ 0,01.

4. Matériau cristallin en oxyde de gallium dopé selon la revendication 1 ou 2, lequel matériau cristallin en oxyde de gallium dopé est un matériau cristallin en **β**-Ga₂O₃ dopé au Ta, et lequel matériau cristallin en **β**-Ga₂O₃ dopé au Ta a au moins l'une parmi une résistivité située dans la plage allant de 2,0 × 10⁻⁴ à 1 × 10⁴ **Ω**•cm et une concentration de supports située dans la plage allant de 5 × 10¹² à 7 × 10²⁰/cm³.

5. Matériau cristallin en oxyde de gallium dopé selon la revendication 4, dans lequel la formule moléculaire du matériau cristallin en **β**-Ga₂O₃ dopé au Ta est Ga₂₍₁₋ₓ₎Ta₂ₓO₃, 0,000001 ≤ x ≤ 0,01.

6. Matériau cristallin en oxyde de gallium dopé selon la revendication 1 ou 2, lequel matériau cristallin en oxyde de gallium dopé est un matériau cristallin en **β**-Ga₂O₃ dopé au Nb ayant au moins l'une parmi une résistivité située dans la plage allant de 2,5 × 10⁻⁴ à 1 × 10⁴ **Ω**•cm et une concentration de supports située dans la plage allant de 5 × 10¹² à 5, 6 × 10²⁰/cm³.

7. Matériau cristallin en oxyde de gallium dopé selon la revendication 6, dans lequel la formule moléculaire du matériau cristallin en **β**-Ga₂O₃ dopé au Nb est Ga₂₍₁₋ₓ₎Nb₂ₓO₃, 0,000001 ≤ x ≤ 0,008.

8. Matériau cristallin en oxyde de gallium dopé selon la revendication 1 ou 2, lequel matériau cristallin en oxyde de gallium dopé est un matériau cristallin en **β**-Ga₂O₃ dopé au V ayant au moins l'une parmi une résistivité située dans la plage allant de 2,0 × 10⁻⁴ à 1 × 10⁴ **Ω**•cm et une concentration de supports située dans la plage allant de 5 × 10¹² à 7 × 10²⁰/cm³.

9. Matériau cristallin en oxyde de gallium dopé selon la revendication 8, dans lequel la formule moléculaire du matériau cristallin en **β**-Ga₂O₃ dopé au V est Ga₂₍₁₋ₓ₎V₂ₓO₃, 0,000001 ≤ x ≤ 0,01.

10. Matériau cristallin en oxyde de gallium dopé selon la revendication 9, dans lequel le matériau cristallin en **β**-Ga₂O₃ dopé au V est un cristal de **β**-Ga₂O₃ dopé au V ;
le matériau cristallin en **β**-Ga₂O₃ dopé au V a au moins l'une parmi une résistivité située dans la plage allant de 2,0 × 10⁻³ à 3,6 × 10² **Ω**•cm et une concentration de supports située dans la plage allant de 3,7 × 10¹⁵ à 6,3 × 10¹⁹/cm³.

11. Matériau cristallin en oxyde de gallium dopé selon la revendication 10, dans lequel le matériau cristallin en **β**-Ga₂O₃ dopé au V est un monocristal de **β**-Ga₂O₃ dopé au V ;
le matériau cristallin en **β**-Ga₂O₃ dopé au V a au moins l'une parmi une résistivité située dans la plage allant de 3 × 10⁻² à 50 **Ω**•cm et une concentration de supports située dans la plage allant de 5 × 10¹⁵ à 3,69 × 10¹⁸/cm³.

12. Procédé pour préparer un matériau cristallin en **β**-Ga₂O₃ dopé au M, comprenant :
le mélange de M₂O₅ et de Ga₂O₃, les M₂O₅ et Ga₂O₃ ayant tous deux une pureté supérieure à 4N, en un rapport molaire de (0,000000000001 à 0,01)/(0,9999999 à 0,99) pour que des cristaux croissent, ce qui donne un matériau cristallin en oxyde de gallium dopé au M, et
le recuit du matériau cristallin en **β**-Ga₂O₃ dopé au M à une température de recuit de 1000°C à 1200°C pendant 3 à 10 heures après la croissance cristalline,
dans lequel M est un élément du Groupe VB, lequel élément M du Groupe VB est le vanadium (V), le niobium (Nb), le tantale (Ta), ou une de leurs combinaisons.

13. Procédé selon la revendication 12, dans lequel les puretés des M₂O₅ et Ga₂O₃ sont toutes deux supérieures à 5N ;
quand le matériau cristallin en **β**-Ga₂O₃ dopé au M est un monocristal de **β**-Ga₂O₃ dopé au M, la pureté du Ga₂O₃ utilisé dans le procédé de préparation est supérieure à 6N ; et
le rapport molaire du M₂O₅ au Ga₂O₃ est de préférence situé dans la plage (0,000001 à 0,01)/(0,999999 à 0,99).

14. Procédé selon la revendication 12, dans lequel, quand le matériau cristallin en **β**-Ga₂O₃ dopé au M est un monocristal de **β**-Ga₂O₃ dopé au M, le monocristal croît par un procédé à l'état fondu qui est l'un quelconque choisi parmi un procédé de tirage en filières (EFG), un procédé de Czochralski, un procédé à zone flottante, ou un procédé de Bridgman.
